# DEMANDE DE BREVET EUROPEEN

(11) **EP 4 033 526 A2**
(43) Date de publication de la demande: **27.07.2022**
(21) Numéro de dépôt: 22152742.7
(22) Date de dépôt: 21.01.2022
(51) Int. Cl.: H01L 23/485, H01L 21/60, H01L 33/62

(54) **STRUCTURE DE MICRO-INSERT EN SILICIUM**

(30) Priorité: 21.01.2021 FR 2100563
(71) Demandeur: Commissariat à l'énergie atomique et aux énergies alternatives, 75015 Paris (FR)
(72) Inventeur: LOURO, Mélanie, 38054 GRENOBLE CEDEX 09 (FR); CAPLET, Stéphane, 38054 GRENOBLE CEDEX 09 (FR)
(74) Mandataire: Brevalex

(57) **Abrégé**

L'invention concerne un composant formant au moins connexion mécanique comportant un substrat (32), muni, sur une de ses faces (32a), d'au moins un micro-élément (20a-20e, 20b', 20₁-20₄) de connexion en silicium, s'étendant selon une direction perpendiculaire à ladite face, entre un pied, proche du substrat, et un sommet, le sommet ayant une largeur (eₜ), mesurée dans un plan parallèle au substrat, supérieure à la largeur (eₚ) d'une partie de l'élément située entre la sommet et le pied et/ou le composant ayant une paroi latérale comportant une surface au moins en partie festonnée.

## Description

### DOMAINE TECHNIQUE ET ART ANTERIEUR

L'invention concerne les techniques d'interconnexion par insertion, dont plusieurs réalisations sont déjà connues pour l'assemblage de composants microélectroniques.

Une première technique est illustrée en figure 1 et est connue du document FR 2 876 244 : selon cette technique, on réalise un assemblage de composants 10, 11 par insertion de pointes conductrices 12 dures dans des protubérances 14 conductrices ductiles formées sur des plots 9. Les pointes sont par exemple obtenues par dépôt métallique, gravure, croissance électrolytique, nano-impression métallique ou croissance de nanotubes alignés à partir de plots 8.

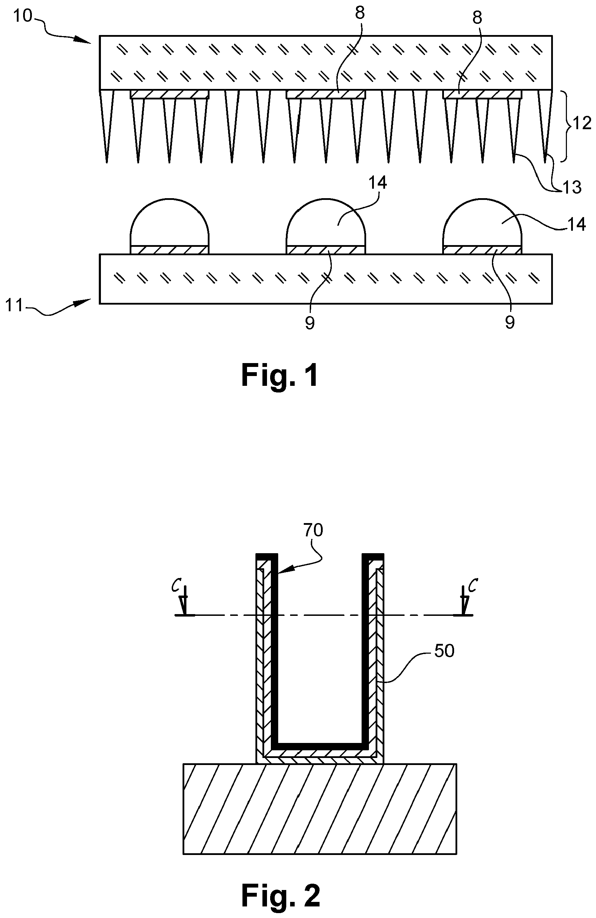

Le document FR2977370 décrit des interconnexions à base de micro-tubes. Une telle interconnexion est illustrée en figure 2 et comporte une âme métallique creuse (50 sur la Figure 2) et une couche métallique (70) constituée d'un métal inoxydable recouvrant la face interne de l'âme métallique afin de la protéger de l'oxydation.

Les inconvénients principaux de ces interconnexions résident dans le nombre d'étapes nécessaires à leur fabrication. De plus, certaines étapes de fabrication ne sont pas « standard ». Par ailleurs, sur certaines coupes observées, les micro-tubes apparaissent dégradés (pliés ou cassés lors de l'étape d'insertion).

Ainsi malgré des avantages certains par rapport à d'autres technologies d'interconnexion, en particulier pour la réalisation d'assemblages hétérogènes, il faut encore trouver de nouvelles structures et de nouveaux procédés de réalisation de micro-tubes.

On cherche notamment de nouvelles structures dont les procédés de réalisation soient plus simples que ceux des structures connues.

### EXPOSE DE L'INVENTION

L'invention concerne d'abord un composant formant au moins connexion mécanique comportant un substrat, muni, sur une de ses faces, d'au moins un micro-élément, ou micro-insert, en silicium, s'étendant selon une direction perpendiculaire à ladite face.

Selon une réalisation particulière, le composant a une paroi latérale dont au moins une partie a une direction faisant un angle non nul avec ladite direction perpendiculaire au substrat.

Ladite paroi latérale peut comporter une surface festonnée et/ou présentant une rugosité et/ou des pics et/ou des stries. Par exemple, l'élément d'interconnexion est réalisé avec la technologie DRIE. Cette technologie permet de créer des profils et une rugosité de flanc favorables à une fonction d'hybridation, assurant une bonne tenue mécanique mais aussi une bonne qualité du contact électrique dans les cas où l'on cherche, à la fois, une hybridation mécanique et électrique.

Selon une autre réalisation particulièrement intéressante, un ou plusieurs micro-élément(s) de connexion en silicium :
- s'étend selon une direction perpendiculaire à ladite face, entre un pied, proche du substrat, et un sommet, le sommet ayant une largeur, mesurée dans un plan parallèle au substrat, supérieure à la largeur d'une partie de l'élément située entre la sommet et le pied ;
- et/ou le composant a une paroi latérale comportant une surface au moins en partie festonnée et/ou présentant une rugosité et/ou des pics et/ou des stries. Là encore, cet élément d'interconnexion est par exemple réalisé avec la technologie DRIE, qui permet de créer des profils et une rugosité de flanc favorables à une fonction d'hybridation, assurant une bonne tenue mécanique mais aussi une bonne qualité du contact électrique dans les cas où l'on cherche, à la fois, une hybridation mécanique et électrique.

Un composant selon l'invention est apte à être connecté mécaniquement avec un autre composant muni, sur une de ses faces, d'un ou plusieurs plots de connexion, par exemple une ou plusieurs protubérances, de préférence en un matériau ductile.

L'invention permet de réaliser un élément d'interconnexion avec une bonne tenue mécanique.

Un élément d'interconnexion d'un composant selon l'invention a par exemple une section, dans un plan perpendiculaire à ladite direction, de forme circulaire ou en croix. En variante, ladite section a une forme de couronne, l'élément d'interconnexion formant un micro-tube. Selon un exemple, un élément d'interconnexion selon l'invention est en forme de micro-pointe. Selon un exemple, un élément d'interconnexion est en forme de pilier.

L'élément d'interconnexion peut être par exemple en silicium polycristallin ou silicium amorphe.

L'élément d'interconnexion peut avoir également des propriétés conductrices lui permettant également de contribuer à une fonction d'interconnexion électrique.

Pour cette raison, au moins un micro-élément:
- peut être dopé pour être conducteur et ainsi participer activement à la conductivité électrique du composant;
- et/ou être revêtu d'une couche métallique d'interface (par exemple en Au, Pt ou Al) ; si la paroi latérale comporte une surface festonnée et/ou présentant une rugosité, cette couche aura de préférence une épaisseur limitée, par exemple comprise entre 20 nm et 100 nm afin de conserver la présence de festons et/ou la rugosité en surface de cette couche métallique d'interface.

Si l'élément d'interconnexion a des propriétés conductrices, le substrat peut comporter au moins une partie d'un circuit électrique ou électronique et des moyens de connexion permettant de connecter électriquement ledit micro - élément et ladite partie de circuit.

Selon une réalisation, le micro - élément est au contact d'une sous-couche d'interface, disposée sur la surface du substrat. Cette sous-couche d'interface est par exemple en SiO₂, ou en SiN, ou en Ti, ou en un alliage Ti/TiN, ou en Al ou en Cu. En variante, notamment si l'élément d'interconnexion a des propriétés conductrices, cette sous-couche d'interface est en un élément conducteur électriquement, par exemple en Ti, ou Ti/TiN ou en Al. Quel que soit son matériau, cette sous-couche d'interface peut avoir une épaisseur comprise par exemple entre 5 nm et 100 nm.

Au moins un micro - élément peut comporter une couche ou un pied d'ancrage sur ladite face du substrat.

Un composant selon l'invention peut comporter une pluralité d'élément d'interconnexion tels que décrits ci-dessus.

L'invention concerne également un dispositif hybride comportant un composant, par exemple un composant électronique, muni d'au moins un plot d'interconnexion, par exemple en un matériau ductile, au moins un composant selon l'invention, tel que décrit ci-dessus ou dans la suite de cette demande, dont au moins un élément d'interconnexion est inséré dans ledit plot d'interconnexion.

L'invention concerne également un procédé de réalisation d'un composant formant au moins connexion mécanique, comportant au moins un élément d'interconnexion mécanique sur un substrat, ou d'un composant tel que décrit ci-dessus, ce procédé comportant :
a) - une étape de formation d'une couche ou d'un substrat en silicium sur une face dudit substrat ;
b) - une étape de gravure, par technique DRIE, de ladite couche ou dudit substrat pour former au moins un élément d'interconnexion s'étendant selon une direction perpendiculaire à ladite face du substrat entre un pied, au niveau ou proche du substrat, et un sommet.

Le ou les élément(s) d'interconnexion mécanique s'étend(ent) selon une direction perpendiculaire à ladite face, et a/ont une paroi latérale dont au moins une partie a une direction faisant un angle non nul avec ladite direction perpendiculaire au substrat. En variante, ladite paroi latérale est droite ou sensiblement perpendiculaire par rapport au substrat, mais cette paroi comporte des motifs dont au moins une partie a une direction faisant un angle non nul avec ladite direction perpendiculaire au substrat.

Selon une réalisation particulièrement intéressante, le sommet a une largeur, mesurée dans un plan parallèle au substrat, supérieure à la largeur d'une partie de l'élément située entre la sommet et le pied et/ou le composant a une paroi latérale comportant une surface au moins en partie festonnée et/ou présentant une rugosité et/ou des pics et/ou des stries, et/ou plus généralement présentant un ou des motif(s) favorable(s) à une fonctions d'hybridation

La mise en oeuvre de la technique « DRIE » permet de réaliser une surface festonnée et/ou présentant une rugosité et/ou des pics et/ou des stries, plus généralement présentant un motif favorable à une fonctions d'hybridation, assurant une bonne tenue mécanique mais aussi une bonne qualité du contact électrique dans les cas où l'on cherche, à la fois, une hybridation mécanique et électrique.

Au moins un élément d'interconnexion peut avoir une section, dans un plan parallèle à ladite face du substrat, en forme de couronne ou de forme circulaire ou en croix. D'autres formes sont également possibles.

Par exemple, au moins un élément d'interconnexion est en forme de pilier ; en variante, il a une forme de micro-tube et a une section, dans un plan parallèle à ladite face du substrat, en forme de couronne, l'étape b) de gravure laissant subsister un creux à l'intérieur dudit élément.

Avant l'étape a), une couche d'interface peut avoir été formée entre la couche de silicium et la surface du substrat.

L'étape de gravure peut être réalisée sur une partie seulement de l'épaisseur de la couche en silicium.

Un procédé selon l'invention peut comporter en outre une étape de dépôt d'une couche métallique sur au moins un élément d'interconnexion et/ou le silicium peut être dopé pour le rendre conducteur. Dans les 2 cas, le substrat peut comporter au moins une partie de circuit auquel l'élément d'interconnexion peut être connecté électriquement.

Selon une réalisation, la couche en silicium est au contact d'une sous-couche d'interface, disposée sur la surface du substrat.

L'étape de gravure peut permettre de réaliser au moins un micro-élément comportant un pied d'ancrage sur ladite face du substrat.

L'invention concerne également un procédé d'assemblage d'un composant muni d'au moins un plot conducteur, de préférence en matériau ductile, et d'un composant selon l'invention, comportant :
- une étape d'alignement des 2 composants, au moins un élément d'interconnexion du composant selon l'invention faisant face à au moins un plot conducteur ;
- une étape de rapprochement des 2 composants, et d'insertion d'au moins un élément d'interconnexion du composant selon l'invention dans au moins un plot conducteur.

Les matériaux mis en oeuvre dans le cadre d'un procédé selon l'invention peuvent être ceux énoncés ci-dessus en lien avec la présentation d'un composant selon l'invention et de ses variantes.

### BRÈVE DESCRIPTION DES DESSINS

- Les figures 1 et 2 représentent des structures d'interconnexion de type connu,
- Les figures 3A-3F représentent divers exemples d'éléments d'interconnexion selon l'invention, en forme de pilier;
- Les figures 4A-4F représentent divers exemples d'éléments d'interconnexion selon l'invention, en forme de micro-tube ;
- La figure 5 représente un un élément d'interconnexion selon l'invention, en forme de pilier;
- les figures 6A - 6C illustrent l'assemblage d'un substrat muni d'un élément d'interconnexion selon l'invention avec un composant muni d'un plot de connexion ;
- la figures 7 est une photographie MEB d'un élément d'interconnexion selon l'invention, en forme de micro-tube, après gravure DRIE;
- les figures 8A - 9B représentent d'autres formes d'éléments d'interconnexion selon l'invention ;
- les figures 10A - 10B représentent des étapes d'un procédé de réalisation d'un élément d'interconnexion selon l'invention, en forme de pilier;
- les figures 10C - 10D représentent des étapes d'un procédé de réalisation d'un élément d'interconnexion selon l'invention, en forme de micro-tube;
- les figures 11A - 11C représentent des étapes d'un autre procédé de réalisation d'un élément d'interconnexion selon l'invention;
- les figures 12A et 12B sont des étapes d'assemblage d'un composant ou circuit muni d'élément d'interconnexion selon l'invention avec un composant muni de plots de connexion ;
- les figures 13A et 13B représentent chacune un composant muni d'éléments d'interconnexion selon l'invention, insérés dans des plots d'un autre composant.

### EXPOSÉ DÉTAILLÉ DE MODES DE RÉALISATION PARTICULIERS

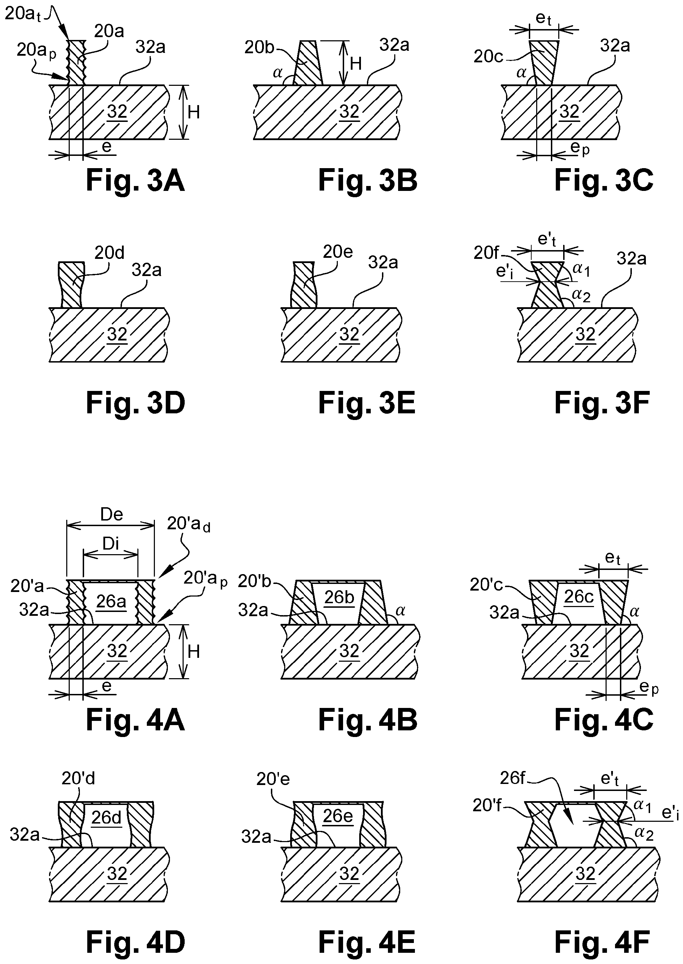

Différents exemples de profils d'un élément (ou micro- élément) d'interconnexion selon l'invention sont représentés en figures 3A-3F ou 4A-4F. D'autres exemples sont donnés dans la suite de la description.

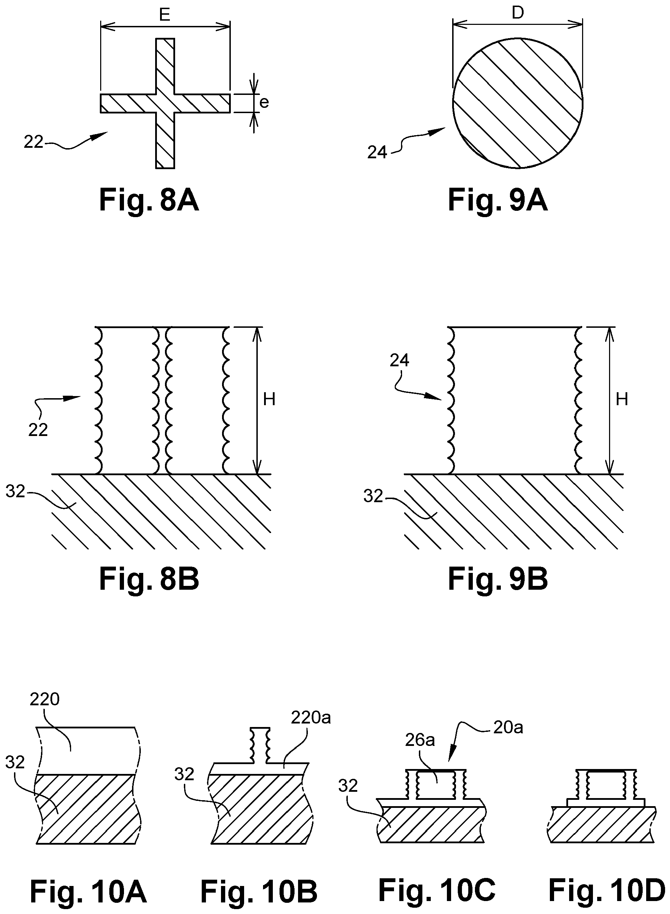

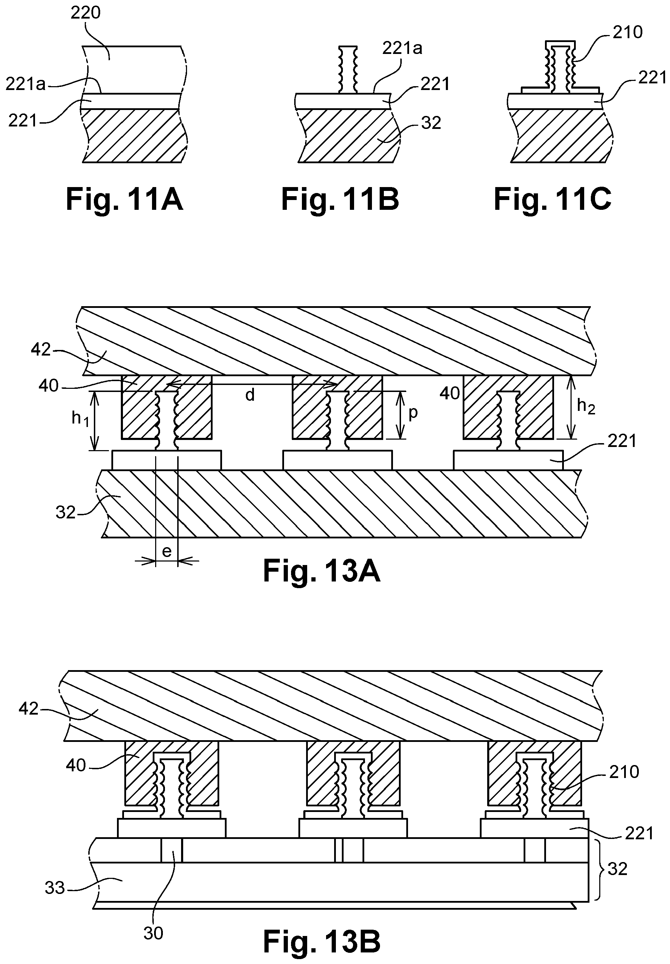

Un tel élément d'interconnexion 20a,...20e (figures 3A-3F) est ici en forme de pilier (ou de plot) s'étendant selon une direction sensiblement perpendiculaire à la surface 32a du substrat 32 sur lequel il repose. Ce pilier peut reposer sur une couche d'interface 221, elle-même formée sur le substrat, comme illustré en figures 11A et 11B. Ou bien il peut être réalisé par gravure partielle de la couche dans laquelle le pilier micro-tube est réalisé, comme illustré en figures 10A et 10B ou 10C et 10D.

La surface de cet élément peut avoir, dans un plan perpendiculaire au substrat, un profil droit (figure 3A) ou à pente positive (figure 3B : l'angle a, extérieur à l'élément, mesuré entre la surface de cet élément et la surface du substrat, est strictement supérieur à 90°) ou négative (figure 3C : l'angle a, extérieur à l'élément, mesuré entre la surface de cet élément et la surface du substrat, est strictement inférieur à 90°) ou avoir deux profils de pente différents, l'un positif et l'autre négatif (figure 3F).

Dans le cas d'un profil à pente négative (figure 3C), la partie de l'élément la plus éloignée du substrat (ou la « tête »), ou opposée au pied de l'élément, a une largeur eₜ, mesurée dans un plan parallèle au substrat, supérieure à celle eₚ du pied, donc au niveau du substrat (ou d'une couche d'interface 211).

Dans le cas (illustré en figure 3F) d'un élément ayant un profil positif (partie inférieure de l'élément, en partant de son pied) puis négatif (partie supérieure de l'élément) la tête de l'élément, opposée au pied, a une largeur e'ₜ, mesurée dans un plan parallèle au substrat, supérieure à celle e'ᵢ d'une partie intermédiaire de l'élément, située entre la tête et le pied ; autrement dit, l'angle α₁, extérieur à l'élément, mesuré entre la surface de la partie supérieure de cet élément (partie située entre sa tête et un plan parallèle au substrat qui passe par la partie la plus étroite du pilier (partie de largeur e'ᵢ)), est strictement inférieur à 90°, tandis que l'angle α₂, extérieur à l'élément, mesuré entre la surface de la partie inférieure de cet élément (partie située entre la partie la plus étroite du pilier (partie de largeur e'ᵢ), et la surface du substrat), est strictement supérieure à 90°. Dans un cas non représenté, un élément a un profil négatif dans sa partie supérieure, puis droit dans sa partie inférieure.

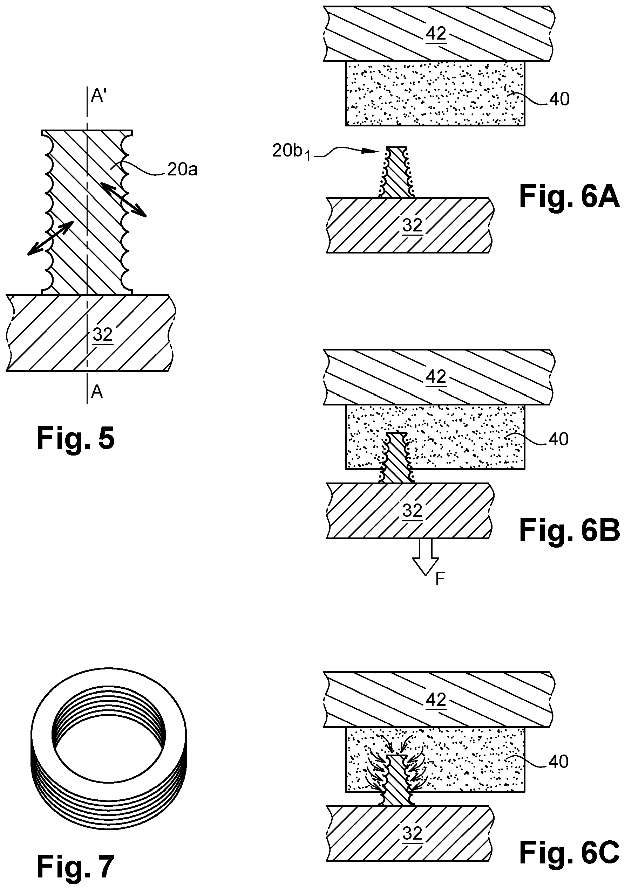

Des profils non linéaires peuvent également être mis en œuvre, c'est-à-dire que l'intersection de la surface de l'élément avec un plan perpendiculaire au substrat sur lequel il est réalisé n'est pas une droite et comporte au contraire au moins une courbure : c'est le cas du pilier représenté en figures 3D et 3E. Très avantageusement, ces profils, de même que le profil à pente positive (figure 3B), sont combinés avec un festonnage, comme expliqué ci-dessous en lien avec la figure 5.

Selon des exemples de dimensionnement des piliers:
- le pilier a par exemple une épaisseur e (mesurée dans un plan parallèle à la surface 32a) comprise entre 0.1 µm et 1 µm;
- et/ou un pilier a une hauteur H comprise entre 2 µm et 5 µm ;
- et/ou un pilier a un rapport d'aspect H/e compris entre 2 et 50, ou de préférence entre 2 et 20 ou encore plus préférentiellement entre 2 et 5.

En variante (figures 4A-4F), un tel élément d'interconnexion selon l'invention 20'a,...20'f comporte un micro-tube s'étendant selon une direction sensiblement perpendiculaire à la surface 32a du substrat 32 sur lequel il repose. Ce tube définit une zone intérieure 26a,...26e, 26f creuse, dont le fond est constitué par la surface 32a sur laquelle le micro-tube est formé. Dans le cas de la présence d'une couche d'interface 221 sur le substrat, comme illustré en figures 11A et 11B, le fond est constitué par la surface 221a de cette couche 221 sur laquelle le micro-tube est formé. Dans le cas d'une gravure partielle de la couche dans laquelle le micro-tube est réalisé, comme illustré en figures 10C et 10D, le fond est constitué par le matériau de la couche elle-même.

La surface de cet élément peut avoir un profil droit (figure 4A) ou à pente positive (figure 4B) ou négative (figure 4C) ou encore avoir deux profils de pente différents, l'un positif et l'autre négatif (figure 4F). Des profils non linéaires peuvent également être mis en œuvre, c'est-à-dire que l'intersection de la surface de l'élément avec un plan perpendiculaire au substrat sur lequel il est réalisé n'est pas une droite et comporte au contraire au moins une courbure : c'est le cas des micro-tubes représentés en figures 4D et 4E. Les explications, données ci-dessus en lien avec les figures 3A-3F, concernant la tête (ou le sommet) et le pied de chaque élément, de même que les profils droits, ou à pente positive et/ou négative s'appliquent ici également. On a d'ailleurs porté en figures 4C et 4F les mêmes références littérales pour identifier les mêmes largeurs et les mêmes angles qu'en figures 3C et 3F.

Selon des exemples de dimensionnement des micro-tubes :
- le diamètre externe Dₑ d'un micro-tube est par exemple compris entre 2 µm et 10 µm ;
- et/ou le diamètre interne Dᵢ d'un micro-tube est par exemple compris entre 1 µm et 5 µm ;
- et/ou la paroi d'un micro-tube a par exemple une épaisseur e (mesurée dans un plan parallèle à la surface 32a) comprise entre 0.1 µm et 1 µm ;
- et/ou un micro-tube a une hauteur H comprise entre 2 µm et 5 µm ;
- et/ou un micro-tube a un rapport d'aspect H/e compris entre 2 et 50, ou de préférence entre 2 et 20 ou encore plus préférentiellement entre 2 et 5.

Comme on le voit sur les différentes figures 3A-3F, et 4A-4F au moins une partie de la surface extérieure et/ou intérieure de l'élément d'interconnexion selon l'invention a, dans un plan perpendiculaire à la surface 32a, une tangente (ou une tangente ayant une composante dans ledit plan perpendiculaire à la surface 32a) faisant un angle non nul avec la direction AA' perpendiculaire à la surface 32a. De plus, des stries ou cannelures ou festons peuvent être réalisés en surface extérieure ou intérieure, comme illustré en figures 3A, 4A et en figure 5.

Dans tous les cas, l'élément d'interconnexion s'étend globalement ou en moyenne selon une direction AA' perpendiculaire au substrat 32, entre un pied, au niveau du substrat ou de la couche d'interface 221 (figures 11A-11C) et une tête (ou le sommet), laquelle est au niveau le plus élevé de l'élément par rapport au substrat : on a identifié en figures 3A (respectivement 4A) le pied 20aₚ (respectivement 20'aₚ) et la tête 20aₜ (respectivement 20'aₜ); au moins une partie de la paroi latérale de l'élément a une direction faisant un angle non nul ladite direction AA'. En variante, la paroi latérale est droite ou sensiblement perpendiculaire par rapport au substrat, mais elle comporte des motifs dont au moins une partie a une direction faisant un angle non nul avec ladite direction perpendiculaire au substrat, comme expliqué ci-dessous en lien avec la figure 5.

On a représenté sur cette figure 5 un agrandissement d'un élément 20a (figure 3A) (ou d'une partie de l'élément 20'a de la figure 4A), sur la surface duquel on voit un aspect de « festonnage » (« scalloping »), sous forme ici d'une suite de segments d'arcs rentrants (ces arcs se répètent le long de la surface, entre le pied et la tête de l'élément), une tangente à chacun de ces segments (les directions de 2 de ces tangentes sont représentées en figure 5) étant non parallèle à la direction AA' le long de laquelle l'élément 20a s'étend. En variante, d'autres motifs, qui peuvent se répéter le long de la surface de l'élément, par exemple en forme de stries et/ou de pics et/ou de rugosité(s) peuvent être réalisés. Ces différents motifs, qui peuvent se répéter ou être périodiques le long de la surface de l'élément, suivant une direction de préférence au moins en partie perpendiculaire à la direction AA' selon laquelle l'élément est orienté, c'est-à-dire perpendiculairement à la surface du substrat 32 :
- ont par exemple une profondeur (différence entre point le plus haut et point le plus bas du motif) comprise entre 10 nm et 50 nm et/ou un pas entre motifs voisins compris par exemple entre 50 nm et 300 nm ;
- et/ou peuvent aussi être réalisés en surface des éléments 20b-20e des figures 3B-3F ou 20'b-20'e des figures 4B-4F. Ainsi, on voit en figure 9A un élément d'interconnexion 20b ayant la forme illustrée en figure 3B, mais avec une surface festonnée.

Tous ces différents motifs peuvent résulter du procédé de réalisation, de préférence de type DRIE comme expliqué ci-dessous.

Un élément d'interconnexion d'un substrat selon l'invention peut avoir une fonction seulement mécanique, comme illustré en figures 6A-6C commentées ci-dessous. Mais chaque élément d'interconnexion, qu'il ait la forme d'un pilier 20a,...20f ou d'un micro-tube 20'a,...20'f, ou une forme différente, peut être en contact avec un via du substrat 32. Comme on peut le comprendre avec la figure 13B, sur laquelle les éléments d'interconnexion ont une forme de pilier, ce via 30 peut être lui-même relié à un élément de circuit 33 électrique ou électronique ou à un circuit électrique ou électronique 33 réalisé dans le substrat 32; on explique plus loin comment un élément d'interconnexion peut avoir une quelconque des formes décrites dans la présente demande et peut assurer une fonction de connexion électrique.

Les figures 6A-6C représentent un exemple d'insertion de l'élément d'interconnexion 20b₁ selon l'invention (structure de la figure 3B avec festonnage), lequel est introduit dans un plot de contact 40 d'un substrat 42, de préférence en un matériau ductile, par exemple en aluminium ou en Indium. Cette configuration permet d'obtenir une pression résiduelle de contact mécanique après insertion qui est plus importante que celle qui résulte de la mise en oeuvre des éléments d'interconnexion connus dans l'état l'art, lesquels comportent des parois verticales et relativement lisses : ainsi, en figure 6B, une force F est exercée sur le substrat afin de séparer celui-ci du substrat 42, mais les motifs, par exemple en forme de festons ou de stries ou de pics ou de rugosités de la surface de l'élément d'interconnexion 20b₁ permettent d'opposer une résistance supplémentaire à cette force F, résistance qui serait inférieure dans le cas de parois verticales et relativement lisses.

La figure 6C représente les pressions de contact qui s'exercent sur les parois de cet élément d'interconnexion 20b₁, minimisant, lorsque cet élément d'interconnexion a en outre une fonction électrique, la résistance électrique d'hybridation ; autrement dit, dans le cas d'une fonction électrique, les pressions de contact favorisent une meilleure conductivité électrique.

Les éléments à la surface desquels il y a un « festonnage » (« scalloping ») confèrent à l'élément un meilleur ancrage dans un plot 40 (comme expliqué en lien avec les figures 6A-6C) ; c'est également le cas d'un élément ayant un profil au moins en partie à pente négative (figures 3C, 3F, 4C, 4F), même avec une surface « lisse » (sans effet de festonnage); ces formes permettent à l'élément de mieux tenir dans le plot une fois enfoncé dans celui-ci: les insert connus, par exemple tels que décrits en lien avec les figures 1 et 2, permettent d'enfoncer facilement l'élément dans un plot, mais peuvent également en sortir plus facilement car aucune force mécanique ne pourra les retenir.

On pourra avantageusement combiner une surface au moins en partie festonnée (avec effet de « scalloping », comme en figure 3A ou 4A ou 5) et avec au moins une pente négative, comme par exemple en figures 3C, 3F, 4C, 4F, ce qui renforce encore plus l'effet d'ancrage dans un plot tel que le plot 40.

La figure 7 représente un exemple d'élément d'interconnexion selon l'invention, ayant une structure de micro-tube, réalisé dans du Si bulk.

Une gravure DRIE (« Deep Reactive Ionic Etching ») d'une couche ou d'un substrat en silicium permet de structurer les flancs de la zone gravée et d'avoir un effet de « scalloping » (ou de « festonnage » ou de « stries » ou de « rugosité »), en particulier comme expliqué ci-dessus en lien avec les figures 3A-6C ou avec la figure 67

Plus particulièrement, la technique de gravure DRIE alterne des étapes de gravure et de passivation. Elle est expliquée dans l'article de Y.Mita et al. intitulé « Aspect ratio dépendent scalloping attenuation in drie and an application to low-loss fiber-optical switches », doi: 10.1109/MEMSYS.2006.1627749, 19th IEEE International Conférence on Micro Electro Mechanical Systems, Istanbul, 22-26 Janvier 2006, p.114-117 et dans US 5501893.

Une pente, comme on le voit par exemple en figures 3B, 3C, 3F, 4B, 4C, 4F ou 6A peut être créée par ce type de procédé, par exemple en jouant sur la tension de polarisation lors de sa mise en oeuvre. On peut éventuellement faire évoluer les conditions de mise en œuvre tout au long de la gravure pour avoir une pente évolutive (comme illustré sur les diverses figures 3A-3F ou 4A-4F).

Les éléments d'interconnexion selon l'invention sont de préférence réalisés en silicium, par exemple en silicium monocristallin ; en variante, ils sont en silicium polycristallin ou en silicium amorphe, par exemple issu d'un dépôt.

Le silicium peut être dopé; par exemple, il est suffisamment dopé pour être conducteur et ainsi participer activement à la conductivité électrique de l'élément d'interconnexion lorsqu'il est hybridé dans un élément de contact, par exemple un plot, d'un autre substrat.

En variante, ou en combinaison avec un dopage (lequel contribue alors à la conduction électrique globale), au moins un élément de connexion en silicium peut être rendu conducteur électrique par un revêtement d'une couche métallique 210 (voir par exemple les figures 11C et 13B). Si la paroi latérale comporte, comme en figures 11C et 13B, une surface festonnée et/ou présente une rugosité et/ou des pics et/ou des stries (comme expliqué ci-dessus), cette couche 210 aura de préférence une épaisseur limitée, par exemple comprise entre 20 nm et 100 nm, afin de conserver la présence de festons et/ou la rugosité et/ou les pics et/ou les stries en surface de cette couche métallique d'interface. Dans les 2 cas (dopage du silicium ou revêtement métallique), un élément d'interconnexion conducteur peut être en contact, directement ou par une sous-couche 221 métallique, avec des moyens conducteurs du substrat 32, par exemple un via 30 comme représenté en figure 13B.

Des éléments d'interconnexion selon l'invention ayant une forme de pilier (figures 3A-3F) puis de micro-tube (figures 4A-4F) ont été décrits ci-dessus.

Cependant, un élément d'interconnexion selon l'invention peut avoir toute forme géométrique, par exemple en pointe, en croix, ou en cylindre, tout en s'étendant selon une direction sensiblement perpendiculaire à la surface 32a du substrat 32 sur laquelle il repose.

Des vues, en coupe (selon un plan parallèle au substrat sur lequel chacun d'entre eux est formé) et de côté, sont représentées en figures 8A-8B pour un élément 22 en forme de croix et en figures 9A-9B pour un élément 24 en forme de cylindre ; la ou les parois présentent les motifs en « festons » (ou autres types de motifs) déjà décrits ci-dessus ; les matériaux et procédés utilisés pour réaliser ces autres formes peuvent être ceux mentionnés ci-dessus, l'élément d'interconnexion pouvant avoir, ou pas, des propriétés de conductivité électrique selon l'application. La forme du masque utilisé pour la gravure de ces éléments est adaptée en fonction de la forme de l'élément d'interconnexion à réaliser.

Selon des exemples de dimensionnement de ces éléments d'interconnexion :
- le diamètre D du cylindre de la figure 9A est par exemple compris entre 0,1µm et 0,5µm ;
- la croix de la figure 8A a des branches d'épaisseur e et/ou une taille E, ou une dimension maximum, mesurée dans un plan parallèle à la surface 32a du substrat 32 par exemple comprise entre 1µm et 5µm ;
- et/ou un micro - élément a un rapport d'aspect H/e compris entre 2 et 50, ou de préférence entre 2 et 20 ou encore plus préférentiellement entre 2 et 5.

Des variantes de ces autres formes peuvent être réalisées, avec une ou des pente(s) latérale(s) positive(s) (comme en figure 3B ou 4B), négative(s) (comme en figure 3C ou 4C), ou positive et négative (comme en figure 3F ou 4F), ou non linéaire(s) (comme en figure 3D ou 3E, ou 4D ou 4E).

Un élément d'interconnexion peut être par exemple obtenu par gravure d'une couche de silicium, par exemple comme illustré en figures 10A et 10B.

Dans l'exemple de ces figures, dans une première étape (figure 10A), la surface 32a d'un substrat 32 est recouverte d'une couche de silicium 220. Cette couche 220 est ensuite gravée, éventuellement partiellement (figure 10B), par technique « DRIE » sur tout ou partie de son épaisseur à l'aide d'un masque (non représenté sur les figures) qui va définir la forme de chaque élément d'interconnexion, par exemple la forme d'un pilier comme sur l'une des figures 3A-3F ou d'un micro-tube comme sur l'une des figures 4A-4E. Il est à noter qu'une gravure directe dans un substrat de Si, sans dépôt d'une couche 220 est également possible, surtout dans le cas où l'aspect mécanique est recherché.

Selon une réalisation particulière (comme illustré en figure 10B pour le cas d'un pilier), on ne grave qu'une partie, par exemple 80-90%, de l'épaisseur de la couche 220, ce qui permet de conserver une couche ou un pied d'ancrage 220a plus ou moins large sur le substrat, renforçant ainsi la tenue mécanique de l'ensemble. Une gravure (lithographie, puis gravure RIE) permet de délimiter latéralement un tel pied d'ancrage.

Les figures 10C et 10D illustrent le cas d'une gravure partielle (DRIE) de la couche 220 en vue de former un micro-tube 20a, la couche de matériau résiduel (par exemple compris entre 100 nm et 200 nm) sur le substrat 32 pouvant être délimitée latéralement par gravure (lithographie, puis gravure RIE, figure 10D). Dans ces 2 cas (figures 10A et 10B), on a là encore une surface d'ancrage (figure 10A) ou un pied d'ancrage (figure 10B) sur le substrat 32.

En variante, comme illustré en figures 11A - 11C, une sous-couche 221 d'interface peut être disposée sous la couche 220, à partir de laquelle un élément d'interconnexion (ici : un pilier) peut être obtenu par gravure, ce qui permet :
- du point de vue mécanique : d'augmenter l'adhérence et la tenue mécanique de l'ensemble constitué par la couche 220 et l'élément d'interconnexion ;
- éventuellement, du point de vue électrique (cas de la figure 11C): une reprise de contact électrique de l'élément d'interconnexion via cette sous-couche.

La sous-couche 221 d'interface est par exemple en SiO₂ ou en SiN (ces 2 exemples ne permettant pas une connexion électrique), ou en Ti, ou en un alliage Ti/TiN, ou en Al. Elle a par exemple une épaisseur de quelques nm à quelques dizaines de nm, par exemple encore comprise entre 5 nm et 100 nm.

La figure 11C représente le cas où l'élément d'interconnexion en silicium a été rendu conducteur électrique par un revêtement 210 d'une couche métallique, en contact électrique avec la sous-couche 221 d'interface, laquelle est alors en matériau conducteur, par exemple en Ti, ou en un alliage Ti/TiN, ou en Al. Cette réalisation permet d'avoir un bon contact électrique d'insertion (dans un plot métallique) de type métal/métal. En variante (non représentée), un élément d'interconnexion en silicium rendu conducteur par dopage est en contact avec la sous-couche 221 d'interface en matériau conducteur, assurant, là aussi, un bon contact électrique.

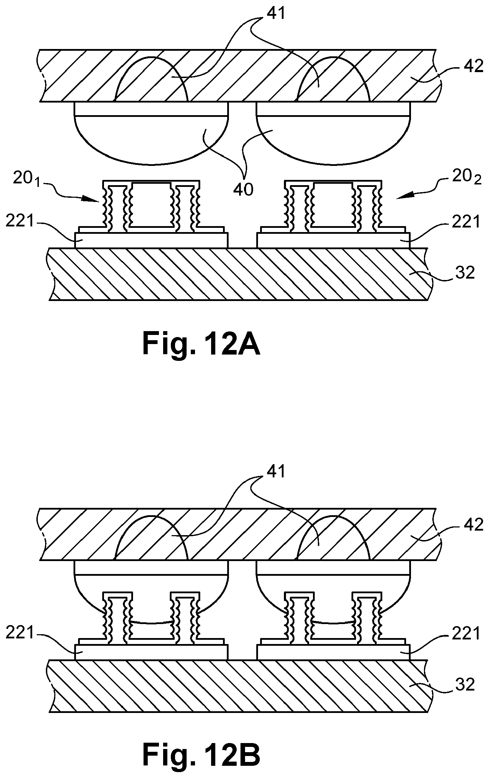

On peut réaliser un ou plusieurs éléments d'interconnexion (comme on le voit en figures 12A et 12A ou en figures 13A-13B, commentées ci-dessous). Un composant selon l'invention peut donc comporter une pluralité d'éléments d'interconnexion, chacun s'étendant selon une direction perpendiculaire au substrat sur lequel ces éléments sont réalisés et chacun ayant une structure telle que décrite ci-dessus. Ces éléments d'interconnexion peuvent être disposés en matrice avec par exemple un pas d'au moins 2 µm ou compris entre 2 µm et 5 µm ou même 10 µm et/ou une distance entre 2 éléments voisins (ou dimension de l'espace libre entre ces 2 éléments) au moins égale à 0,2 µm ou comprise entre 0,2 µm et 5 µm ou entre 0,2 µm et 10 µm.

Comme représenté en figures 12A et 12B, les éléments d'interconnexion 20₁-20₂ d'un composant selon l'invention peuvent être insérés dans des plots (ou « pads ») 40 d'accueil, de préférence en un matériau ductile, par exemple de l'aluminium ou de l'indium, formés sur un substrat 42 d'un composant. Ce dernier peut être un composant électronique comportant des éléments tels que des diodes 41, en contact avec les plots 40, ou bien un circuit électronique et des moyens de connexion, par exemple des vias tels que les vias 30, qui relient ce circuit et les plots 40. Le substrat 32 peut être par exemple un circuit de lecture de type CMOS ; ou bien, il peut avoir la structure décrite ci-dessous en lien avec la figure 13B, avec des éléments tels que des moyens de connexion, par exemple des via, reliés à un élément de circuit ou un circuit 33 réalisé dans le substrat 32.

L'opération de connexion des deux composants peut être réalisée à l'aide d'un équipement de « flip-chip». L'assemblage est effectué en deux étapes :
- un alignement, de préférence à température ambiante, des deux circuits (figure 12A) ;
- puis une mise en contact et une hybridation (figure 12B); celle-ci est effectuée en appliquant une force perpendiculairement au plan d'assemblage.

Sur les figures 12A et 12B, les éléments d'interconnexion 20₁-20₂ :
- sont en forme de micro-tubes, mais toute autre forme de l'élément d'interconnexion présentée dans la présente demande peut être utilisée ;
- sont conducteurs du point de vue électrique, en contact avec un pied 221 en matériau conducteur.

Les figures 13A et 13B représentent chacune une configuration d'une telle matrice après hybridation avec un composant comportant un substrat 42 muni d'une pluralité de plots 40 en matériau ductile; les éléments d'interconnexion sont ici des micro-inserts droits (ayant par exemple la forme représentée en figures 9A et 9B), à surface extérieure festonnée.

Selon un exemple de réalisation (voir figure 13A):
- l'épaisseur de la couche dans laquelle les micro-éléments de connexion sont réalisés (laquelle épaisseur est égale à la hauteur h₁ de chaque micro-élément) est comprise entre 0.5 µm et 3 µm ;
- et/ou la taille (ou section ou largeur de paroi ou de gravure) e, mesurée suivant un axe parallèle à la surface du substrat 32) du micro-élément est comprise entre 0.2 µm et 0.5 µm ou entre 0.2 µm et 1 µm ;
- et/ou le pas d de la matrice de micro-éléments est compris entre 2 µm et 10 µm ;
- et/ou la profondeur d'insertion p des micro - éléments dans les plots 40 est comprise entre 50 et 100% de la hauteur h₁ du micro - élément; cette gamme permet une bonne tenue mécanique, mais aussi, éventuellement, un bon contact électrique;
- et/ou la hauteur h₂ de chaque plot 40 est de 1 à 2 fois la hauteur h₁ du micro-élément qui est inséré dans ce plot, ce qui permet une bonne tenue mécanique.

Dans le cas de la figure 13B, chaque élément d'interconnexion est rendu conducteur électrique par un revêtement 210 d'une couche métallique et est en contact électrique avec une sous-couche 221 d'interface. Cette dernière est elle-même en contact avec un via 30 du substrat 32, chaque via 30 étant relié à un élément de circuit ou un circuit 33 réalisé dans le substrat 32. L'application illustrée ici est de type « micro-display » : le dispositif 42 est par exemple de type « micro-led » et est hybridé sur circuit 32 de lecture CMOS. L'invention permet par exemple d'assembler un circuit de lecture 32 à un composant 42 qui peut être pixellisé et hétérogène, par exemple de type « display » (ou de type écran de montre ou d'appareil photo ou d'appareil de télévision) ; en variante, le composant 42 peut être un détecteur infrarouge refroidi.

## Revendications

1. Composant formant au moins connexion mécanique comportant un substrat (32), muni, sur une de ses faces (32a), d'au moins un micro-élément (20a-20e, 20b', 20₁-20₄) de connexion en silicium, s'étendant selon une direction perpendiculaire à ladite face, entre un pied, proche du substrat, et un sommet, le sommet ayant une largeur, mesurée dans un plan parallèle au substrat, supérieure à la largeur d'une partie de l'élément située entre la sommet et le pied et/ou le composant ayant une paroi latérale comportant une surface au moins en partie festonnée.

2. Composant selon l'une des revendications 1, ladite paroi latérale ayant, dans un plan perpendiculaire à ladite face, un profil non linéaire.

3. Composant selon l'une des revendications 1 ou 2, au moins un micro - élément étant au moins en partie en silicium polycristallin ou en silicium amorphe, ou bien étant en silicium dopé pour être conducteur et/ou étant revêtu d'une couche métallique (210) et/ou étant en silicium dopé pour être conducteur, et/ou le substrat (32) portant au moins une partie d'un circuit (33) électrique ou électronique et des moyens (30) de connexion électrique dudit micro-élément et de ladite partie d'un circuit (33).

4. Composant selon l'une des revendications 1 à 3, au moins un micro-élément (20, 20a-20e) étant au contact d'une sous-couche d'interface (221), par exemple en SiO₂, et/ou en SiN, et/ou en Ti, et/ou en un alliage Ti/TiN, et/ou en Al.

5. Composant selon la revendication 4, la sous-couche d'interface ayant une épaisseur comprise entre 5 nm et 100 nm.

6. Composant selon l'une des revendications 1 à 5, au moins un micro-élément (20, 20a-20e) comportant un pied d'ancrage (220a) sur ladite face (32a) du substrat (32).

7. Composant selon l'une des revendications 1 à 6, comportant une pluralité d'élément d'interconnexion.

8. Dispositif hybride comportant un composant (42) muni d'au moins un plot d'interconnexion (40), au moins un composant selon l'une des revendications 1 à 6, dont au moins un élément d'interconnexion est inséré dans ledit plot d'interconnexion.

9. Dispositif hybride selon la revendication 8, ledit plot d'interconnexion (40) étant en un matériau ductile.

10. Procédé de réalisation d'un composant formant connexion mécanique, comportant au moins un élément d'interconnexion mécanique (20) sur un substrat (32), ce procédé comportant :
a) - une étape de formation d'une couche (220) ou d'un substrat (230) en silicium sur une face dudit substrat (32);
b) - une étape de gravure, par technique DRIE, de ladite couche (220) ou dudit substrat (230) pour former au moins un élément d'interconnexion (20) s'étendant selon une direction perpendiculaire à ladite face du substrat (32) entre un pied, proche du substrat, et un sommet, le sommet ayant une largeur, mesurée dans un plan parallèle au substrat, supérieure à la largeur d'une partie de l'élément située entre la sommet et le pied et/ou le composant ayant une paroi latérale comportant une surface au moins en partie festonnée.

11. Procédé selon la revendication 10, au moins un élément d'interconnexion ayant une section, dans un plan parallèle à ladite face du substrat (32), en forme de couronne ou de forme circulaire ou en croix.

12. Procédé selon la revendication 11, au moins un élément d'interconnexion étant en forme de micro-tube et ayant une section, dans un plan parallèle à ladite face du substrat (32), en forme de couronne, l'étape b) de gravure laissant subsister un creux (26) à l'intérieur dudit élément.

13. Procédé selon l'une des revendications 10 à 12, une couche d'interface (221) étant formée entre la couche de silicium et la surface (32a) du substrat (32).

14. Procédé selon l'une des revendications 10 à 13, l'étape de gravure étant réalisée sur une partie seulement de l'épaisseur de la couche (220) en silicium.

15. Procédé selon l'une des revendications 10 à 14, comportant en outre une étape de dépôt d'une couche métallique (210) sur au moins un élément d'interconnexion.
